(19) Europäisches Patentamt
European Patent Office
Office européen des brevets

(11) **EP 4 191 507 A1**

(12) **EUROPEAN PATENT APPLICATION**
published in accordance with Art. 153(4) EPC

(43) Date of publication:
**07.06.2023 Bulletin 2023/23**

(21) Application number: **21850376.1**

(22) Date of filing: **26.07.2021**

(51) International Patent Classification (IPC):
***G06Q 50/08*** *(2012.01)*

(52) Cooperative Patent Classification (CPC):
**G06Q 50/08**

(86) International application number:
**PCT/JP2021/027443**

(87) International publication number:
**WO 2022/024951 (03.02.2022 Gazette 2022/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.07.2020 JP 2020129630**

(71) Applicant: **FUJIFILM Corporation
Tokyo 106-8620 (JP)**

(72) Inventor: **HORITA, Shuhei
Tokyo 106-8620 (JP)**

(74) Representative: **Meissner Bolte Partnerschaft
mbB
Patentanwälte Rechtsanwälte
Postfach 86 06 24
81633 München (DE)**

(54) **STRUCTURE INVESTIGATION SUPPORT DEVICE, STRUCTURE INVESTIGATION SUPPORT METHOD, AND PROGRAM**

(57)    An inspection support device of a structure that perceivably presents candidates of access means to an inspection position of the structure, an inspection support method of a structure, and a program are provided. An inspection support device of a structure includes a processor (20). The processor (20) is configured to acquire a three-dimensional model of a structure that is an inspection target, and accessible range information of a plurality of types of access means for accessing an inspection position of the structure, display the three-dimensional model on a display unit, receive a designation of the inspection position on the displayed three-dimensional model, and display information about one or more types of the access means for accessing the inspection position on the display unit based on the received inspection position and the accessible range information.

FIG. 2

20

| INFORMATION ACQUISITION UNIT | 51 |
| THREE-DIMENSIONAL MODEL DISPLAY UNIT | 53 |
| DESIGNATION RECEIVING UNIT | 55 |
| INFORMATION DISPLAY UNIT | 57 |

EP 4 191 507 A1

**Description**

**BACKGROUND OF THE INVENTION**

1. Field of the Invention

The present invention relates to an inspection support device of a structure, an inspection support method of a structure, and a program.

2. Description of the Related Art

In the related art, an inspection support technology for supporting an inspector in performing an inspection work of a structure has been suggested.
For example, JP2002-222281A suggests a technology for the purpose of imaging a structure, detecting a defect from a captured image, and simply and accurately calculating a cost for repairing the defect.
Here, a damage may be found in a case where screening is performed by visual inspection of the inspector at a distance or by capturing an approximate image of the entire structure using a drone (unmanned flying object) or the like, and detailed inspection close to the found damage may be necessary.

**SUMMARY OF THE INVENTION**

There are a large number of access means to an inspection position of the structure. Accordingly, it may be difficult for the inspector to perceive by which means a desired inspection position can be accessed, and design of the access means may not be easy.
The present invention is conceived in view of such circumstances, and an object thereof is to provide an inspection support device of a structure that perceivably presents candidates of access means to an inspection position of the structure, an inspection support method of a structure, and a program.
An inspection support device of a structure that is an aspect of the present invention for accomplishing the above object is an inspection support device of a structure, comprising a processor, in which the processor is configured to acquire a three-dimensional model of a structure that is an inspection target, and accessible range information of a plurality of types of access means for accessing an inspection position of the structure, display the three-dimensional model on a display unit, receive a designation of the inspection position on the displayed three-dimensional model, and display information about one or more types of the access means for accessing the inspection position on the display unit based on the received inspection position and the accessible range information.
It is preferable that the inspection support device of a structure further comprises a memory that stores the three-dimensional model and the accessible range information, in which the processor is configured to acquire the three-dimensional model and the accessible range information from the memory.
It is preferable that the memory stores an image of the structure associated with the three-dimensional model, and the processor is configured to detect a damage from the image, and automatically receive the designation of the inspection position based on the detected damage.
It is preferable that the memory stores damage information associated with the three-dimensional model, and the processor is configured to display the damage information on the three-dimensional model.
It is preferable that the processor is configured to acquire surrounding environment information indicating a surrounding environment of the structure, and display the information about the access means for accessing the inspection position based on the surrounding environment information, the inspection position, and the accessible range information.
It is preferable that the inspection support device of a structure further comprises a memory that stores the surrounding environment information, in which the processor is configured to acquire the surrounding environment information from the memory.
It is preferable that the processor is configured to acquire required unit inspection time information indicating a time required for inspection for each type of the access means, and in a case of displaying the information about the access means, display the required unit inspection time information corresponding to the displayed information about the access means.
It is preferable that the inspection support device of a structure further comprises a memory that stores the required unit inspection time information, in which the processor is configured to acquire the required unit inspection time information from the memory.
It is preferable that the processor is configured to calculate at least one of a required time for each inspection position or a required time for performing inspection at all inspection positions based on the inspection position and the required unit inspection time information, and display the calculated required time.

It is preferable that the processor is configured to acquire expense information indicating an expense required for inspection for each type of the access means, and in a case of displaying the information about the access means, display the expense information corresponding to the displayed information about the access means.

It is preferable that the inspection support device of a structure further comprises a memory that stores the expense information, in which the processor is configured to acquire the expense information from the memory.

It is preferable that the processor is configured to calculate at least one of an inspection expense for each inspection position or an inspection expense for performing inspection at all inspection positions based on the inspection position and the expense information, and display the calculated inspection expense.

It is preferable that the inspection position is a position at which the structure is viewed or tapped.

It is preferable that the inspection position is an imaging target position indicating a range in which the structure is imaged.

It is preferable that the processor is configured to acquire an imaging condition for imaging the structure, acquire an imaging position based on the inspection position and the imaging condition, and display the information about the access means with respect to the imaging position.

It is preferable that the inspection support device of a structure further comprises a memory that stores the imaging condition, in which the processor is configured to acquire the imaging condition from the memory.

It is preferable that the processor is configured to display the imaging position.

An inspection support method of a structure that is another aspect of the present invention is an inspection support method of a structure using an inspection support device of a structure including a processor, the method causing the processor to execute a step of acquiring a three-dimensional model of a structure that is an inspection target, and accessible range information of a plurality of types of access means for accessing an inspection position of the structure, a step of displaying the three-dimensional model on a display unit, a step of receiving a designation of the inspection position on the displayed three-dimensional model, and a step of displaying information about one or more types of the access means for accessing the inspection position on the display unit based on the received inspection position and the accessible range information.

A program that is still another aspect of the present invention is a program causing an inspection support device of a structure including a processor to execute an inspection support method of a structure, the program causing the processor to execute a step of acquiring a three-dimensional model of a structure that is an inspection target, and accessible range information of a plurality of types of access means for accessing an inspection position of the structure, a step of displaying the three-dimensional model on a display unit, a step of receiving a designation of the inspection position on the displayed three-dimensional model, and a step of displaying information about one or more types of the access means for accessing the inspection position on the display unit based on the received inspection position and the accessible range information.

According to the present invention, the information about one or more types of the access means for accessing the inspection position is presented based on the designated inspection position and the accessible range information. Thus, a user can easily design the access means.

**BRIEF DESCRIPTION OF THE DRAWINGS**

Fig. 1 is a block diagram illustrating an example of a hardware configuration of an inspection support device of a structure.

Fig. 2 is a block diagram illustrating processing functions implemented by a CPU.

Fig. 3 is a diagram illustrating information and the like stored in a storage unit.

Fig. 4 is a flowchart illustrating an inspection support method of the structure using the inspection support device of the structure.

Fig. 5 is a diagram for describing specific examples of a three-dimensional model display step and a designation receiving step.

Fig. 6 is a diagram for describing specific examples of the three-dimensional model display step and the designation receiving step.

Fig. 7 is a diagram for describing specific examples of the three-dimensional model display step and the designation receiving step.

Fig. 8 is a diagram for describing specific examples of the three-dimensional model display step and the designation receiving step.

Fig. 9 is a diagram illustrating an aerial work vehicle that is an example of access means.

Fig. 10 is a diagram illustrating a work range diagram that is an example of accessible range information.

Fig. 11 is a diagram illustrating a bridge inspection vehicle that is an example of the access means.

Fig. 12 is a diagram illustrating the work range diagram that is an example of the accessible range information.

Fig. 13 is a diagram illustrating the work range diagram that is an example of the accessible range information.

Figs. 14A and 14B are diagrams for describing rope access that is an example of the access means.

Fig. 15 is a diagram illustrating a ladder that is an example of the access means.

Figs. 16A and 16B are diagrams illustrating an example of display of information about the access means.

Fig. 17 is a diagram illustrating information and the like stored in the storage unit.

Fig. 18 is a concept diagram illustrating an unmanned flying object (drone) that is an example of the access means.

Fig. 19 is a concept diagram illustrating a bridge inspection ship that is an example of the access means.

Fig. 20 is a diagram illustrating an example of the display of the information about the access means.

Fig. 21 is a diagram illustrating information and the like stored in the storage unit.

Fig. 22 is a diagram illustrating an example of a required unit inspection time.

Fig. 23 is a diagram illustrating information and the like stored in the storage unit.

Fig. 24 is a diagram illustrating an example of expense information.

Fig. 25 is a diagram illustrating information and the like stored in the storage unit.

Fig. 26 is a diagram for describing presentation of an imaging position.

Fig. 27 is a diagram illustrating a gondola vehicle that is an example of the access means.

Fig. 28 is a diagram illustrating the work range diagram that is an example of the accessible range information.

Fig. 29 is a diagram illustrating a suspended robot that is an example of the access means.

Figs. 30A and 30B are diagrams illustrating a pole camera that is an example of the access means.

## DESCRIPTION OF THE PREFERRED EMBODIMENTS

Hereinafter, a preferred embodiment of an inspection support device of a structure, an inspection support method of a structure, and a program according to the present invention will be described in accordance with the appended drawings.

<First Embodiment>

[Hardware Configuration of Inspection Support Device of Structure]

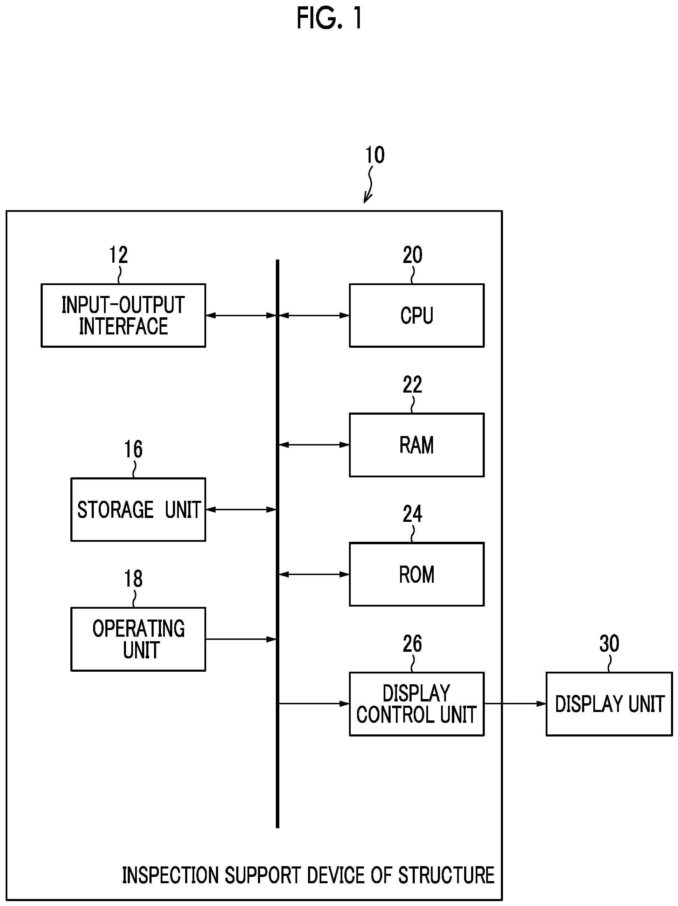

Fig. 1 is a block diagram illustrating an example of a hardware configuration of the inspection support device of the structure according to the embodiment of the present invention.

A computer or a workstation can be used as an inspection support device 10 of the structure illustrated in Fig. 1. The inspection support device 10 of the structure in the present example is mainly composed of an input-output interface 12, a storage unit 16, an operating unit 18, a central processing unit (CPU) 20, a random access memory (RAM) 22, a read only memory (ROM) 24, and a display control unit 26. A display unit 30 is connected to the inspection support device 10 of the structure, and display is performed on the display unit 30 under control of the display control unit 26 under an instruction of the CPU 20. For example, the display unit 30 is composed of a monitor.

The input-output interface 12 can input various data (information) into the inspection support device 10 of the structure. For example, data stored in the storage unit 16 described later is input via the input-output interface 12.

The CPU (processor) 20 controls each unit by reading out various programs stored in the storage unit 16, the ROM 24, or the like, loading the programs into the RAM 22, and performing calculation. In addition, the CPU 20 performs various types of processing of the inspection support device 10 of the structure by reading out the programs stored in the storage unit 16 and the ROM 24 and performing calculation using the RAM 22.

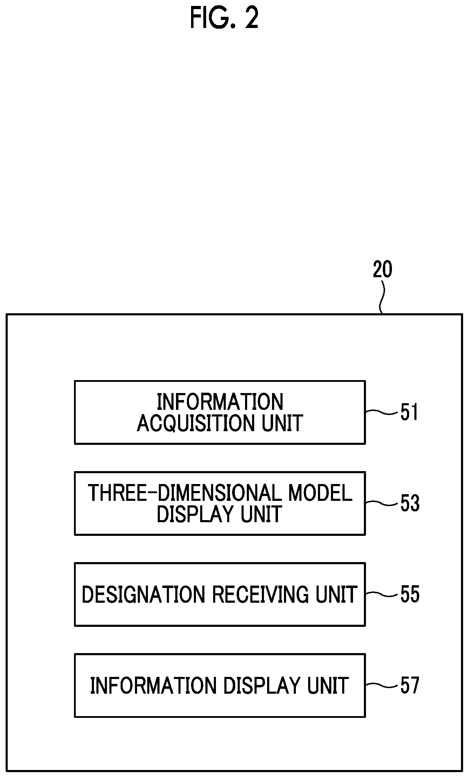

Fig. 2 is a block diagram illustrating processing functions implemented by the CPU 20.

The CPU 20 includes an information acquisition unit 51, a three-dimensional model display unit 53, a designation receiving unit 55, and an information display unit 57. Specific processing functions of each unit will be described later.

Returning to Fig. 1, the storage unit (memory) 16 is a memory composed of a hard disk apparatus, a flash memory, or the like. The storage unit 16 stores data and programs for operating the inspection support device 10 of the structure, such as an operating system and a program for executing the inspection support method of the structure. In addition, the storage unit 16 stores information and the like, described below, used in the present embodiment.

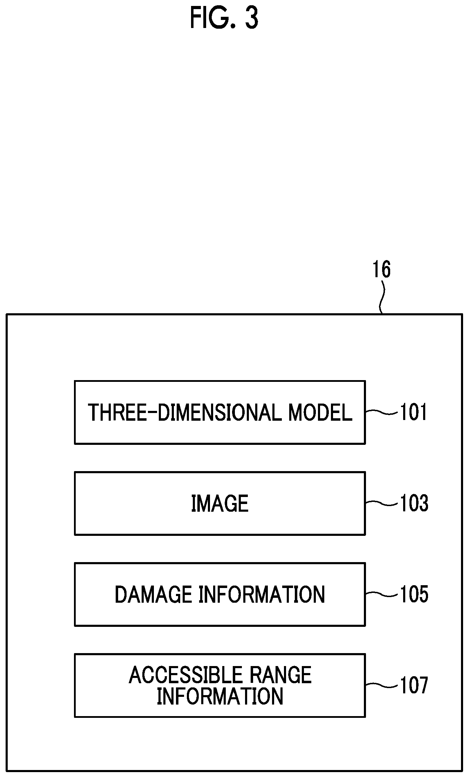

Fig. 3 is a diagram illustrating the information and the like stored in the storage unit 16.

The storage unit 16 mainly stores a three-dimensional model 101, an image 103, damage information 105, and accessible range information 107.

The three-dimensional model 101 is a model indicating a structure as an inspection target. Here, the three-dimensional model 101 is not particularly limited as long as the three-dimensional model 101 is three-dimensional information indicating a shape of the structure as the inspection target. For example, the three-dimensional model 101 corresponds to a three-dimensional computer-aided design (CAD) indicating the structure, a point group model, a texture model, and a solid model. The structure includes a built object, for example, an engineered structure such as a bridge, a tunnel, and a dam and also includes a constructed object such as a building, a house, and a wall, a pillar, and a beam of a building.

The image 103 is an image of the structure associated with the three-dimensional model 101. For example, the image 103 is a captured image obtained by imaging the structure that is the inspection target, and is pasted on a surface of the structure represented by the three-dimensional model 101 as a texture. In a case where a damage is present in the structure, the damage is captured in the image 103, and the damage can be detected from the image 103.

The damage information 105 is information related to the damage associated with the three-dimensional model 101. For example, the damage information 105 is information about the damage of the structure that is the inspection target. For example, the damage information 105 is a damage model indicating a type, a shape, and a size of the damage. Specifically, a damage model of fissuring is a model image indicating a fissuring shape, and a damage model of stripping is a model image indicating a stripping shape. In addition, the damage model has positional information (three-dimensional coordinates) on the three-dimensional model 101 corresponding to a part in which the structure actually has the damage. The three-dimensional model display unit 53 can display the damage model on the display unit 30 in a superimposed manner on the three-dimensional model 101.

The accessible range information 107 is information indicating an accessible range of access means for accessing an inspection position. The access means corresponds to various means for accessing, that is, approaching, the inspection position. Specific examples of the access means include a ladder, a mobile scaffold, a mobile hanging scaffold, a bridge inspection vehicle, a floating scaffold (working barge + scaffold), a gondola vehicle, an aerial work vehicle, rope access, and a bridge inspection ship. Here, the inspection position indicates a part in which detailed inspection close to the structure that is the inspection target is necessary. Specifically, an inspector views or taps close to the structure that is the inspection target at the inspection position. In addition, the inspection position may indicate an imaging target position that indicates a range captured by imaging close to the structure. Specifically, the inspector acquires a captured image in which the inspection position is captured.

Returning to Fig. 1, the operating unit 18 includes a keyboard, a mouse, and the like that are connected to a computer in a wired or wireless manner, and functions as the operating unit 18 for providing a normal operating instruction of the computer. In addition, the operating unit 18 receives a designation of the inspection position by designating a part of the three-dimensional model 101 displayed on the display unit 30 by a user.

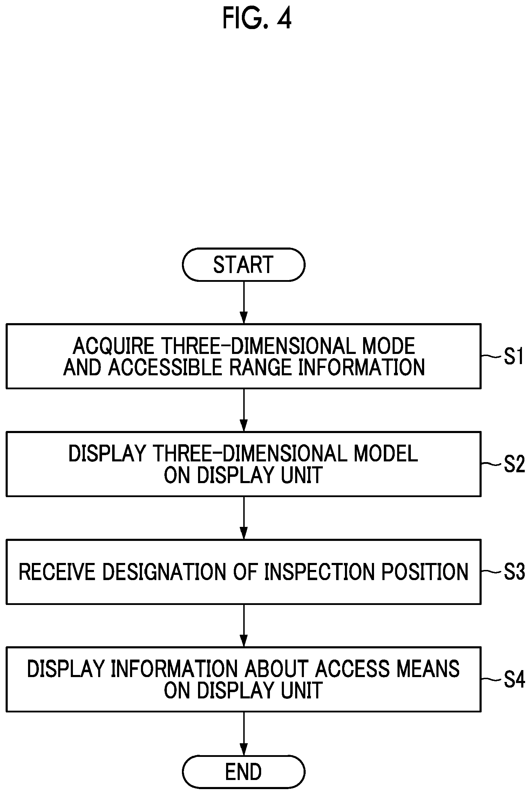

Fig. 4 is a flowchart illustrating the inspection support method of the structure using the inspection support device 10 of the structure.

First, the information acquisition unit 51 acquires the three-dimensional model of the structure that is the inspection target, and the accessible range information 107 (information acquisition step: step S 1). Then, the three-dimensional model display unit 53 displays the acquired three-dimensional model on the display unit 30 (three-dimensional model display step: step S2). Next, the designation receiving unit 55 receives the designation of the inspection position on the three-dimensional model (designation receiving step: step S3). Next, the information display unit 57 of the access means displays information about one or more types of the access means for accessing the inspection position on the display unit 30 based on the received inspection position and the accessible range information 107 (information display step of the access means: step S4). Hereinafter, each step will be described in detail.

<Information Acquisition Step>

The information acquisition step (step S 1) is performed by the information acquisition unit 51. The information acquisition unit 51 acquires the three-dimensional model 101 of the structure and the accessible range information 107 stored in the storage unit 16. In a case where the three-dimensional model 101 and the accessible range information 107 are not stored in the storage unit 16, the information acquisition unit 51 acquires the three-dimensional model 101 and the accessible range information 107 from an outside. For example, the information acquisition unit 51 acquires the three-dimensional model 101 and the accessible range information 107 through a network via the input-output interface 12.

In addition, the information acquisition unit 51 can acquire the image 103 and/or the damage information 105 together with the three-dimensional model 101. In a case where the "three-dimensional model 101 and the image 103" are displayed on the display unit 30, in a case where the "three-dimensional model 101 and the damage information 105" are displayed on the display unit 30, or in a case where the "three-dimensional model 101, the image 103, and the damage information 105" are displayed on the display unit 30, the information acquisition unit 51 acquires each of the image 103 and the damage information 105 to be displayed.

<Three-Dimensional Model Display Step and Designation Receiving Step>

The three-dimensional model display step (step S2) is performed by the three-dimensional model display unit 53. In addition, the designation receiving step (step S3) is performed by the designation receiving unit 55.

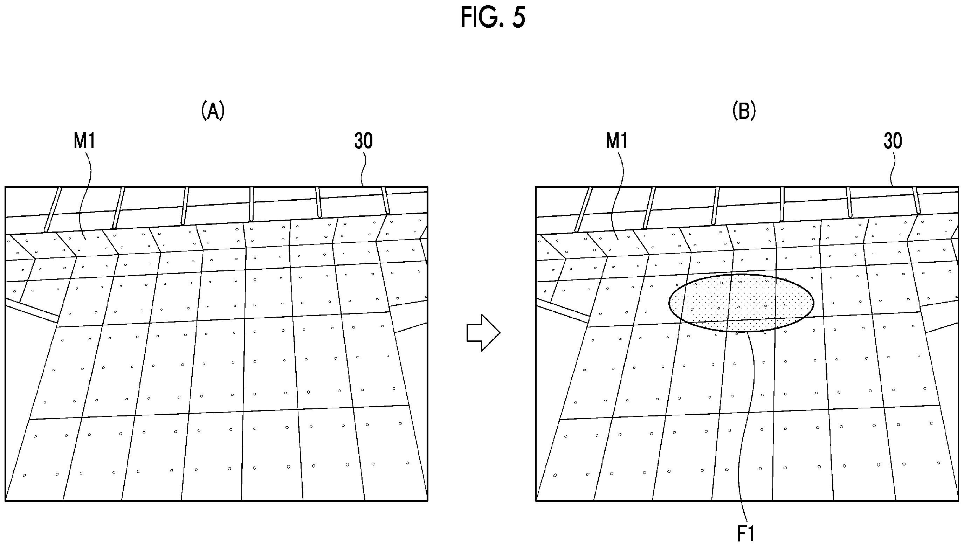

Fig. 5 to Fig. 8 are diagrams for describing specific examples of the three-dimensional model display step and the designation receiving step. In Fig. 5 to Fig. 8, a texture model on which a captured image (image 103) of a bridge corresponding to the three-dimensional model is pasted as a texture is displayed as the three-dimensional model.

[Example 1]

Fig. 5 is a diagram illustrating a three-dimensional model displayed on the display unit 30 and a designated inspection position in Example 1.

(A) of Fig. 5 is a diagram illustrating a three-dimensional model M1 displayed on the display unit 30. The three-dimensional model M1 is a diagram illustrating a pier as the inspection target. The user views the three-dimensional model M1 displayed on the display unit 30 and designates a part in which close inspection is necessary on the three-dimensional model M1.

(B) of Fig. 5 is a diagram for describing a case where an inspection position F1 is designated.

The user manually designates a part (inspection position F1) for which a determination that close inspection is necessary is made, on the three-dimensional model M1 via the operating unit 18. The designation receiving unit 55 receives the position designated by the operating unit 18 on the three-dimensional model M1.

[Example 2]

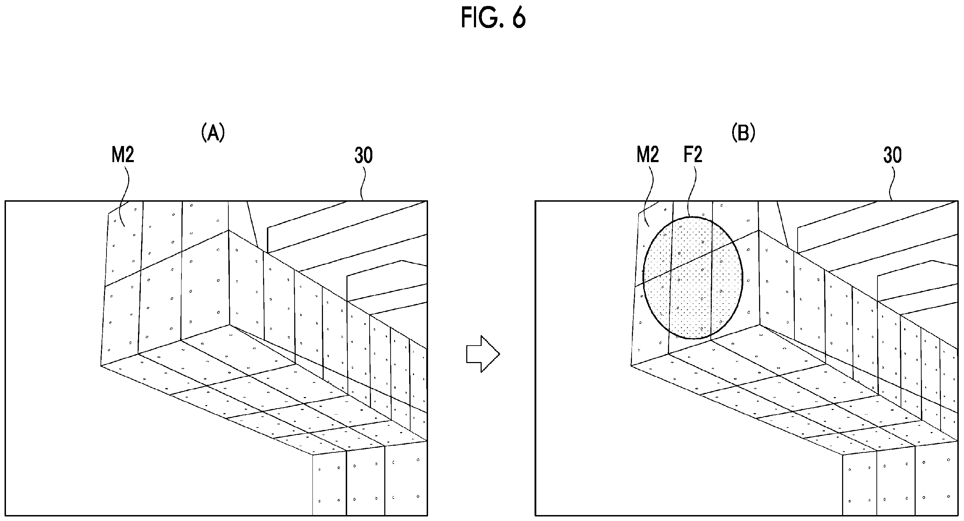

Fig. 6 is a diagram illustrating a three-dimensional model displayed on the display unit 30 and a designated inspection position in Example 2.

(A) of Fig. 6 is a diagram illustrating a three-dimensional model M2 displayed on the display unit 30. The three-dimensional model M2 is a diagram illustrating an upper portion of a pier as the inspection target. The user views the three-dimensional model M2 displayed on the display unit 30 and designates a part in which close inspection is necessary on the three-dimensional model M2.

(B) of Fig. 6 is a diagram for describing a case where an inspection position F2 is designated.

The user manually designates a part (inspection position F2) for which a determination that close inspection is necessary is made, on the three-dimensional model M2 via the operating unit 18. The designation receiving unit 55 receives the position designated by the operating unit 18 on the three-dimensional model M2.

[Example 3]

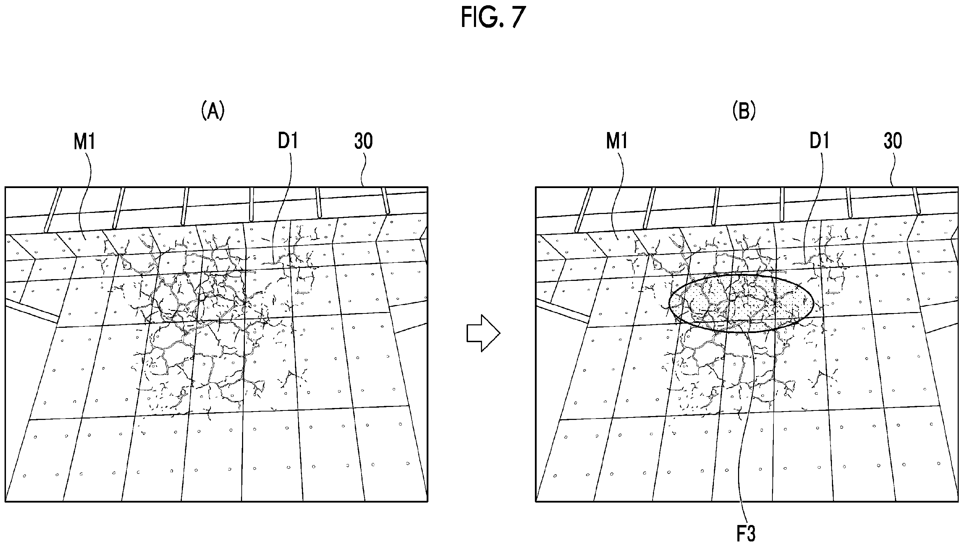

Fig. 7 is a diagram illustrating a three-dimensional model displayed on the display unit 30 and a designated inspection position in Example 3.

(A) of Fig. 7 is a diagram illustrating the three-dimensional model M1 displayed on the display unit 30. The three-dimensional model M1 of the present example has damage information D1. The damage information D1 is a damage model of fissuring. In the present example, the user can view the three-dimensional model M1 having the damage information D1, determine that close inspection is necessary, and designate an inspection position F3.

(B) of Fig. 7 is a diagram for describing a case where the inspection position F3 is designated.

The user manually designates a part (inspection position F3) for which a determination that close inspection is necessary is made, on the three-dimensional model M1 via the operating unit 18. The user can view the damage information D1 displayed on the display unit 30 and designate a part in which the damage information D1 is concentrated (a part in which fissuring is concentrated) as the inspection position F3.

By displaying the damage information D1 in a superimposed manner on the three-dimensional model M1, the user can easily determine a part in which close inspection is necessary, and accurately designate the inspection position.

[Example 4]

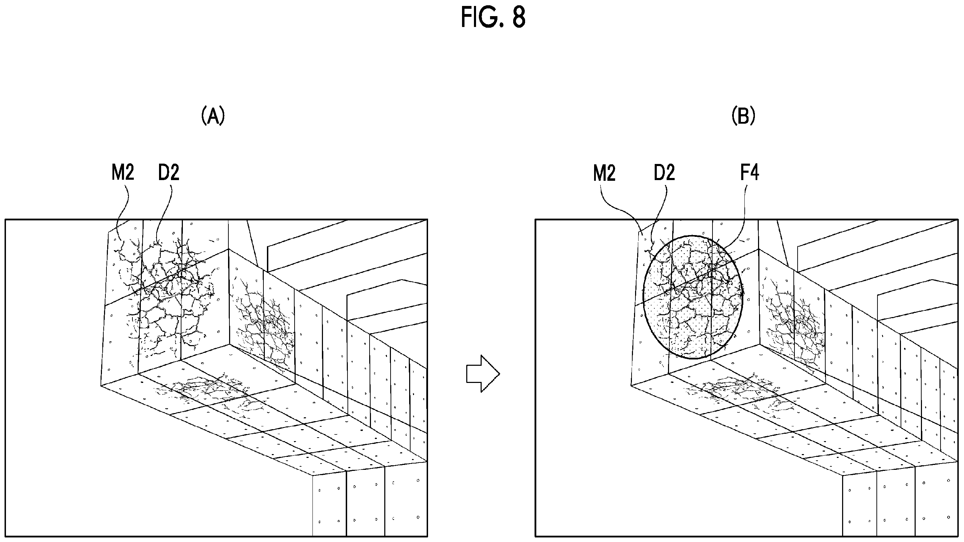

Fig. 8 is a diagram illustrating a three-dimensional model displayed on the display unit 30 and a designated inspection position in Example 4.

(A) of Fig. 8 is a diagram illustrating the three-dimensional model M2 displayed on the display unit 30. The three-dimensional model M2 of the present example has damage information D2. The damage information D2 is a damage model of fissuring. In the present example, the user can view the three-dimensional model M2 having the damage information D2, determine that close inspection is necessary, and designate an inspection position F4.

(B) of Fig. 8 is a diagram for describing a case where the inspection position F4 is designated.

The user manually designates a part (inspection position F4) for which a determination that close inspection is necessary is made, on the three-dimensional model M2 via the operating unit 18. For example, the user can view the damage information D2 and designate a part in which the damage information D2 is concentrated (a part in which fissuring is concentrated) as the inspection position F4.

By displaying the damage information D2 in a superimposed manner on the three-dimensional model M2, the user can easily determine a part in which close inspection is necessary, and accurately designate the inspection position.

While a case where the user manually designates the inspection position has been described in the above examples, the designation of the inspection position is not limited thereto. The designation receiving unit 55 may automatically receive the inspection position. In a case where the inspection position is automatically designated, the inspection position is designated based on, for example, damage information D. For example, the inspection position may be automatically designated based on a detection result or a quantification result of the damage such as a part in which fissuring of which a thickness, a length, or the like is greater than or equal to a threshold value occurs, a part in which fissuring having a hexagonal shape occurs, or a part in which stripping of which an area is greater than or equal to a threshold value occurs.

<Information Display Step of Access Means>

The information display step (step S4) of the access means is performed by the information display unit 57. The information display unit 57 displays information about one or more types of the access means for accessing the inspection position on the display unit 30 based on the received inspection position and the accessible range information 107.

[Access Means and Accessible Range Information]

First, the access means and the accessible range information 107 will be described. Various types of the access means for performing detailed inspection close to the inspection position can be employed. Hereinafter, specific examples of the access means and the accessible range information 107 will be described.

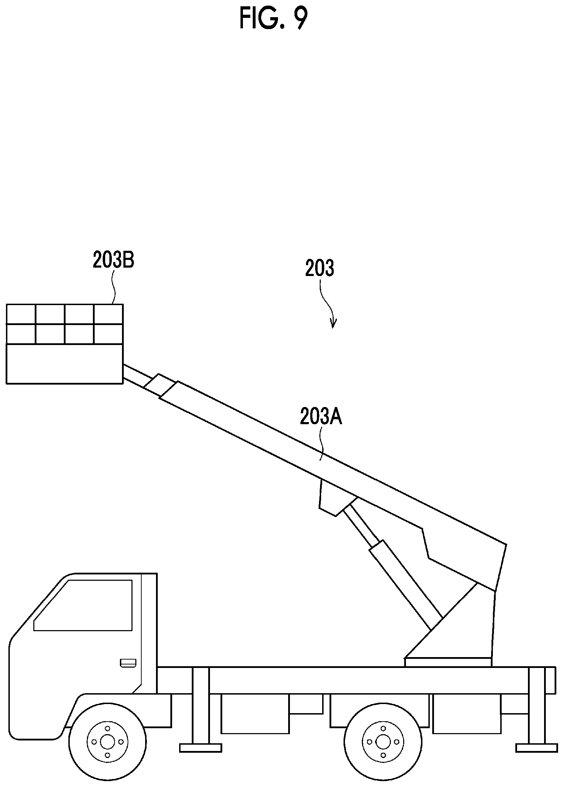

Fig. 9 is a diagram illustrating an aerial work vehicle that is an example of the access means.

As illustrated in Fig. 9, in an aerial work vehicle 203, a basket 203B is provided at a tip end of a boom 203A. The inspector can access an aerial inspection position by riding in the basket 203B and expanding and contracting the boom 203A.

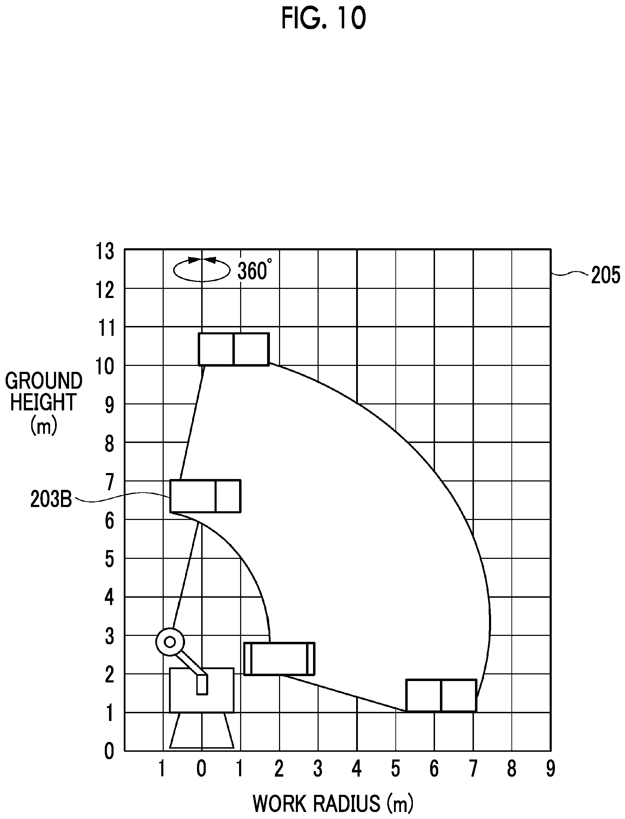

Fig. 10 is a diagram illustrating a work range diagram that is an example of the accessible range information 107 of the aerial work vehicle 203.

A work range diagram 205 illustrates a work range of the aerial work vehicle 203 as a diagram. Specifically, the work range diagram 205 illustrates a reach range in a vertical direction and a work radius in a horizontal direction of the basket 203B of the aerial work vehicle 203.

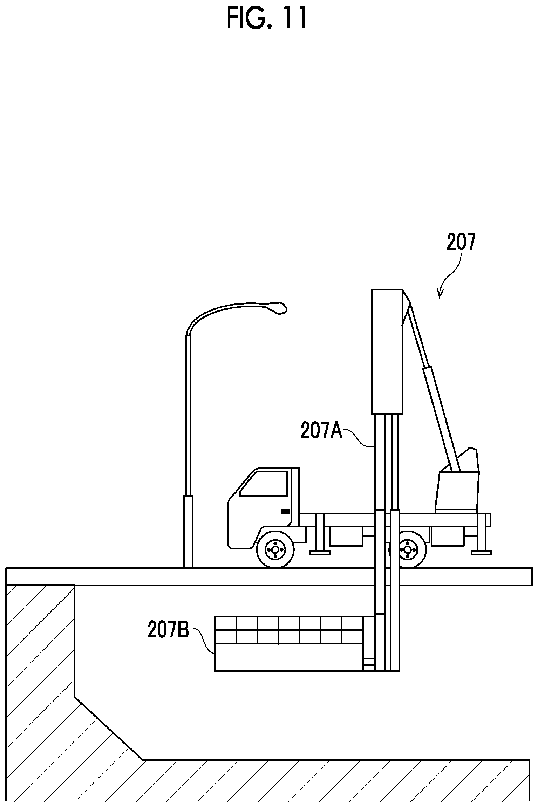

Fig. 11 is a diagram illustrating a bridge inspection vehicle that is an example of the access means.

As illustrated in Fig. 11, in a bridge inspection vehicle 207, a basket 207B is provided at a tip end of a boom 207A. The inspector can access the inspection position by riding in the basket 207B and expanding and contracting the boom 207A.

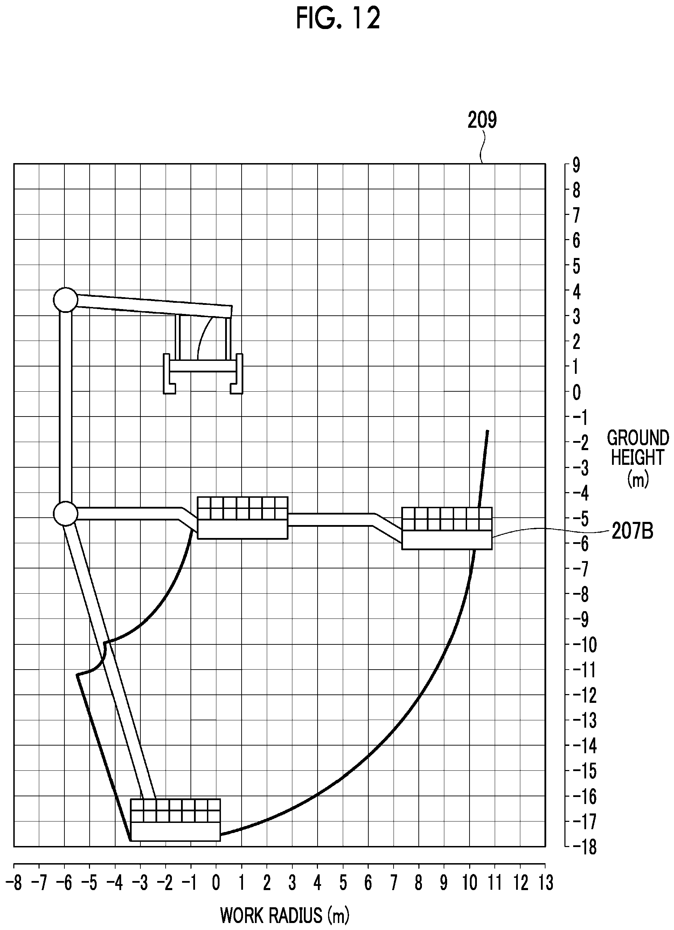

Fig. 12 is a diagram illustrating the work range diagram that is an example of the accessible range information 107 below the bridge inspection vehicle 207.

A work range diagram 209 illustrates a work range of the bridge inspection vehicle 207 as a diagram. The work range diagram 209 illustrates a work radius and a reachable ground height of the basket 207B of the bridge inspection vehicle 207.

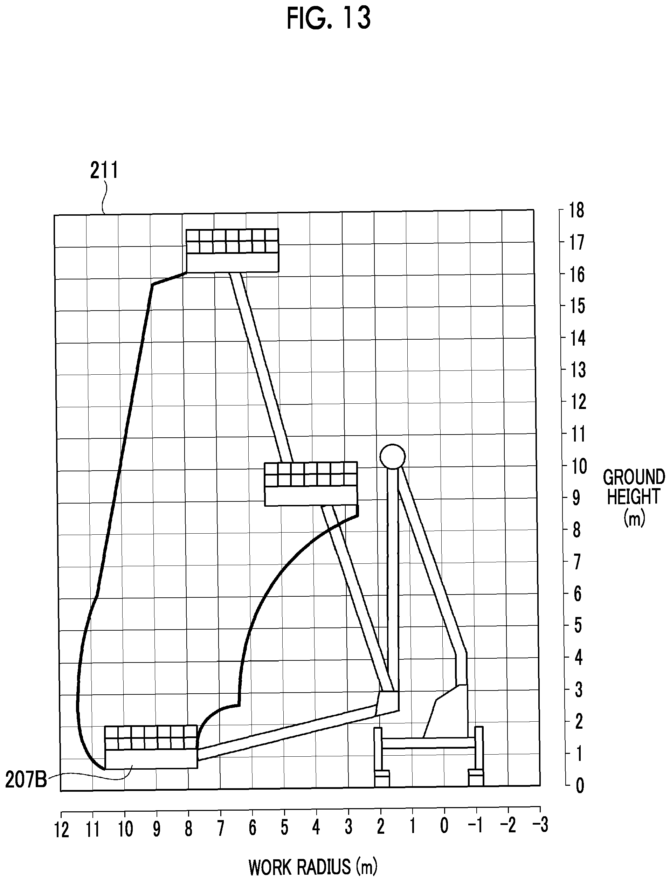

Fig. 13 is a diagram illustrating the work range diagram that is an example of the accessible range information 107 above the bridge inspection vehicle 207.

A work range diagram 211 illustrates the work range of the bridge inspection vehicle 207 as a diagram. The work range diagram 211 illustrates the work radius and the reachable ground height of the basket 207B of the bridge inspection vehicle 207.

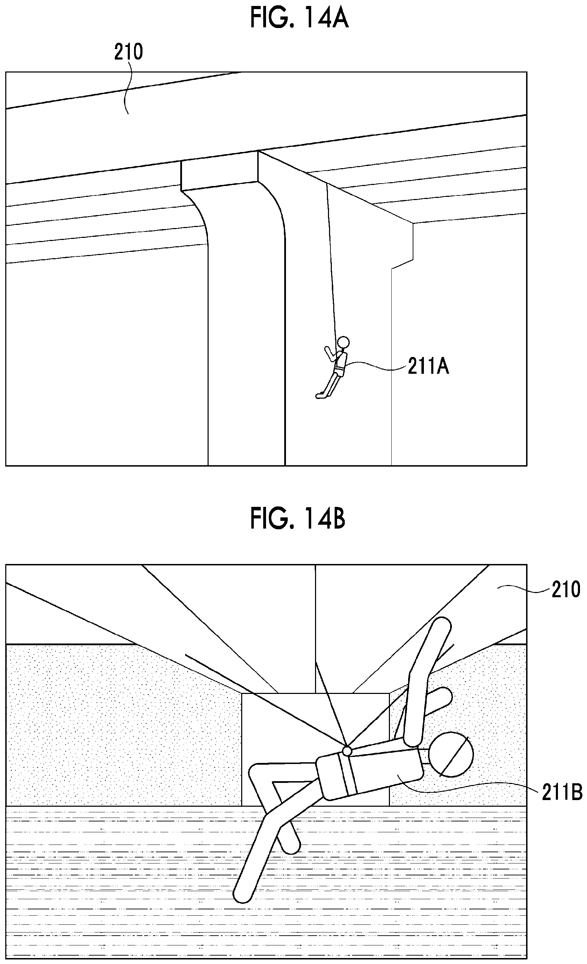

Figs. 14A and 14B are diagrams for describing rope access that is an example of the access means.

As illustrated in Fig. 14A, an inspector 211A can access an aerial inspection position of a bridge 210 by rope access. In addition, as illustrated in Fig. 14B, an inspector 211B can access an inspection position on an underside of the bridge 210 by rope access. The accessible range information 107 of rope access indicates that access can be made without restrictions on the reachable ground height and the work range.

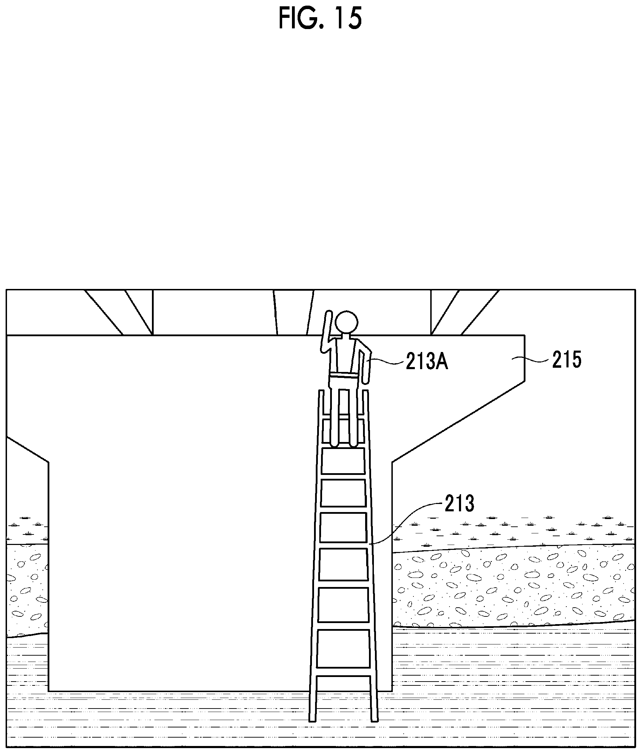

Fig. 15 is a diagram illustrating a ladder that is an example of the access means.

As illustrated in Fig. 15, an inspector 213A can access an aerial inspection position using a ladder 213. Specifically, the inspector 213A can perform detailed inspection close to the aerial inspection position of a pier 215 using the ladder 213.

[Display of Information about Access Means]

Next, display of information about the access means will be described. The information display unit 57 determines accessibility by each type of the access means from the inspection position designated on the three-dimensional model and the accessible range information 107. The information display unit 57 displays information about the access means based on the determined accessibility. The three-dimensional model has information related to dimensions of a structure that is a target of the model (the structure that is the inspection target). The information display unit 57 can obtain information as to where the inspection position designated on the three-dimensional model is positioned in the actual structure portion. Accordingly, the information display unit 57 can determine the accessibility by each type of the access means by comparing the inspection position in actual dimensions with the accessible range information 107.

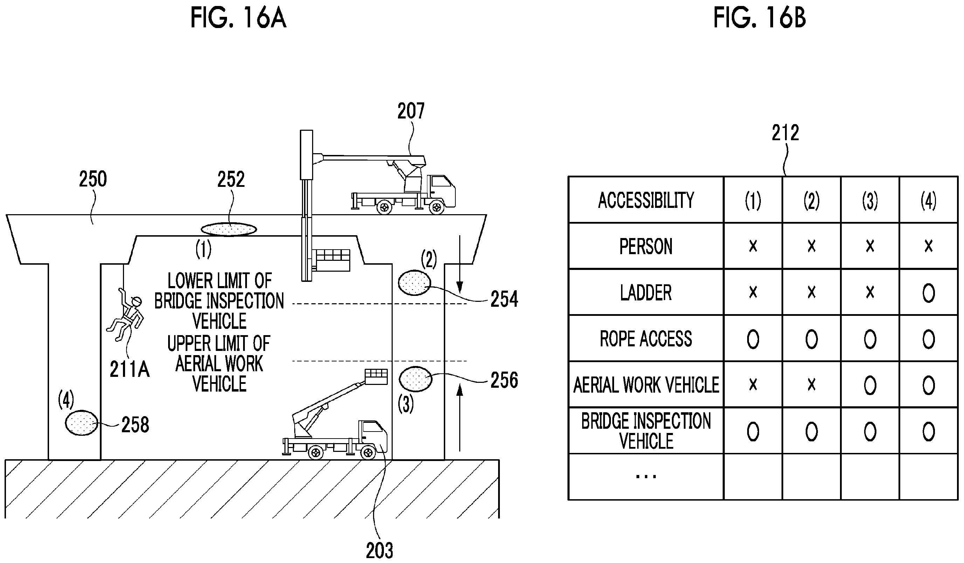

Figs. 16A and 16B are diagrams illustrating an example of the display of the information about the access means displayed on the display unit 30 by the information display unit 57.

Fig. 16A is a diagram illustrating an image display of the information about the access means with respect to inspection positions (1) to (4) designated on a three-dimensional model 250 of a bridge. Fig. 16B is a diagram illustrating the information about the access means with respect to the inspection positions (1) to (4) in a list.

The inspection position (1) (denoted by reference numeral 252) is positioned on an underside of the bridge. The inspection position (1) can be accessed by the bridge inspection vehicle 207 and rope access (refer to a list 212). Thus, the bridge inspection vehicle 207 (image display) and the inspector 211A (image display) of rope access are displayed near the inspection position (1).

The inspection position (2) (denoted by reference numeral 254) is positioned in an upper portion of a pier. The inspection position (2) can be accessed by the bridge inspection vehicle 207 and rope access (refer to the list 212). Thus, the bridge inspection vehicle 207 (image display) is displayed near the inspection position (2).

The inspection position (3) (denoted by reference numeral 256) is positioned in a middle portion of the pier. The inspection position (3) can be accessed by rope access, the aerial work vehicle 203, and the bridge inspection vehicle 207 (refer to the list 212). Thus, the aerial work vehicle 203 (image display) is displayed near the inspection position (3) on the three-dimensional model 250.

The inspection position (4) (denoted by reference numeral 258) is positioned in a lower portion of a pier. The inspection position (4) can be accessed by the ladder 213, rope access, the aerial work vehicle 203, and the bridge inspection vehicle 207 (refer to the list 212). Thus, the inspector 211A of rope access and the aerial work vehicle 203 are displayed near the inspection position (4) on the three-dimensional model 250.

As described above, the information display unit 57 may perform image display of the access means by which access can be made on the three-dimensional model 250 (Fig. 16A) and display the list 212 (Fig. 16B), or may display any one thereof (Fig. 16A or Fig. 16B). In addition, in a case of performing image display of the access means by which access can be made on the three-dimensional model 250 (Fig. 16A) and displaying the list 212 (Fig. 16B), an accessible part may be displayed on the three-dimensional model in a different color in a case where the user selects access means on the list 212. In addition, while an example in which a plurality of the inspection positions are designated has been described in the above description, the present embodiment is not limited to this example. For example, the inspection support device 10 of the structure may present one type of the access means with respect to one inspection position.

As described so far, in the present embodiment, the information about one or more types of the access means for accessing the inspection position is displayed based on the received inspection position and the accessible range information 107. Accordingly, the user can easily perceive candidates of the access means to the inspection position.

<Second Embodiment>

Next, a second embodiment will be described. In the present embodiment, the information about the access means is displayed further based on information related to a surrounding environment of the inspection position.

[Surrounding Environment Information]

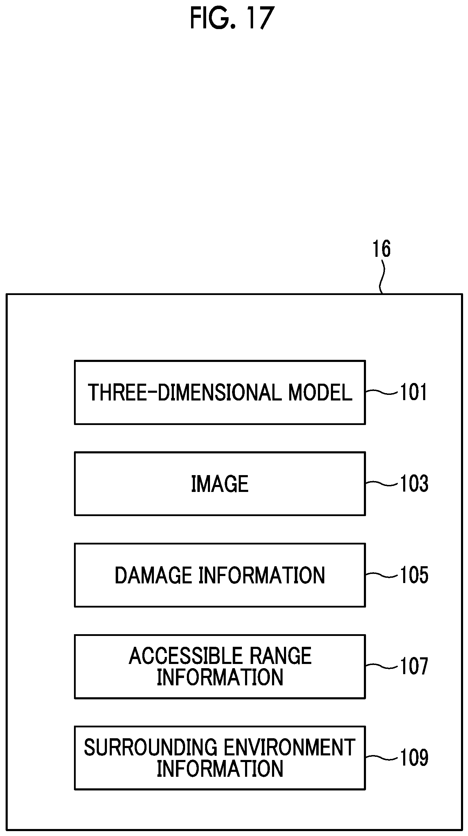

Fig. 17 is a diagram illustrating the information and the like stored in the storage unit 16 of the present embodiment. Parts already described using Fig. 3 will be designated by the same reference numerals and will not be described.

The storage unit 16 of the present embodiment stores the three-dimensional model 101, the image 103, the damage information 105, the accessible range information 107, and surrounding environment information 109.

The surrounding environment information 109 is information indicating a surrounding environment of the structure as the inspection target or a surrounding environment of the inspection position. Examples of the surrounding environment information 109 include information indicating whether an under surface footing environment is a ground surface or a water surface. In addition, in a case where the under surface footing environment is the ground surface, the surrounding environment information 109 may include information as to whether the ground surface is a plane or an inclined surface or whether the ground surface is leveled or not leveled. In addition, in a case where the under surface footing environment is the water surface, the surrounding environment information 109 may include information as to whether or not the water surface is a river or a sea, a speed of flow, and strength of waves. In addition, other examples of the surrounding environment information 109 include information related to a geographical environment. For example, the information related to the geographical environment is information related to, for example, vegetation (trees and the like) around the structure that is the inspection target, a road type (a highway road, a national road, a prefectural road, or a city road) of roads included in the structure that is the inspection target, and a zoning type (a residential area, a commercial area, or an industrial area) of areas in which the structure that is the inspection target is present. In addition, other examples of the surrounding environment information 109 include information related to a meteorological environment around the structure. For example, the information related to the meteorological environment is an average wind speed. In addition, other examples of the surrounding environment information 109 include information related to a traffic volume and presence of electrical cables around the structure.

[Access Means In Case Where Under Surface Footing Environment Is Water Surface]

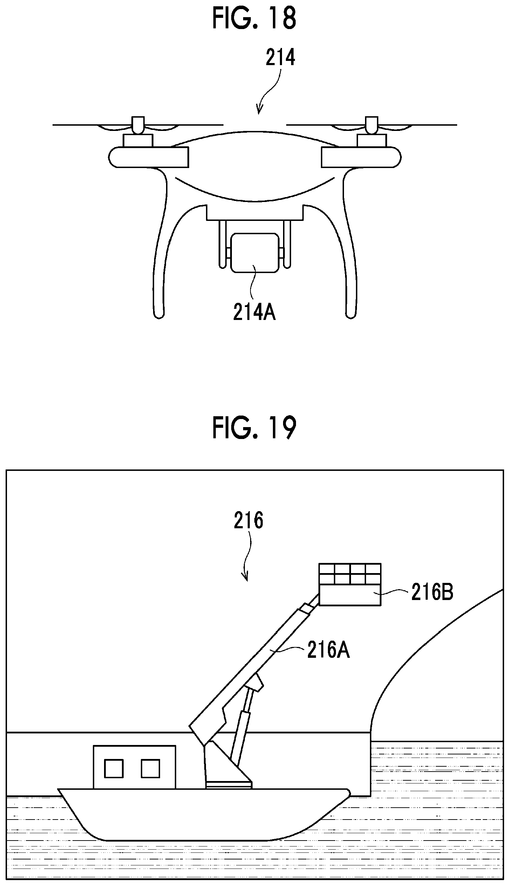

Fig. 18 and Fig. 19 are diagrams illustrating an example of the access means in a case where the under surface footing environment is the water surface.

Fig. 18 is a concept diagram illustrating an unmanned flying object (drone) 214 that is an example of the access means.

The unmanned flying object 214 flies to access the inspection position. For example, this access means is effective for the inspection position at a high position or a location such as a sea or a river in which a footing of the access means cannot be secured. The unmanned flying object 214 includes a camera 214A and can capture a captured image of the inspection position using the camera 214A.

Fig. 19 is a concept diagram illustrating a bridge inspection ship 216 that is an example of the access means.

The bridge inspection ship 216 can access the inspection position even in a case where the footing for accessing the inspection position is the water surface. The bridge inspection ship 216 accesses a desired inspection position by moving on the water surface and expanding and contracting a boom 216A to move a basket 216B.

[Display of Information about Access Means]

The information acquisition unit 51 acquires the surrounding environment information 109 from the storage unit 16. The information display unit 57 displays the information about the access means for accessing the inspection position based on the designated inspection position, the accessible range information 107, and the surrounding environment information 109.

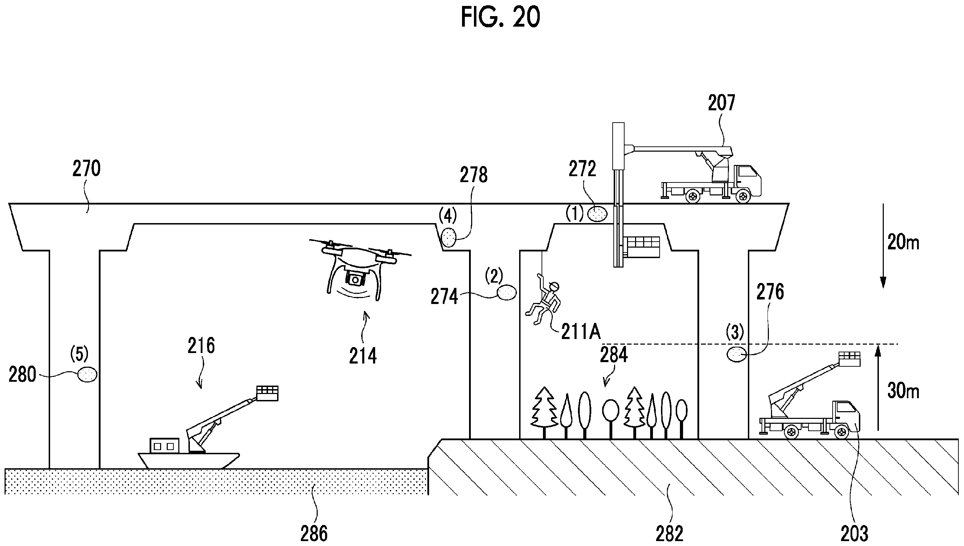

Fig. 20 is a diagram illustrating an example of the display of the information about the access means displayed on the display unit 30 by the information display unit 57.

The inspection position (1) to an inspection position (5) are designated on a three-dimensional model 270 of a bridge.

The bridge inspection vehicle 207 is presented as the access means for accessing the inspection position (1) (denoted by reference numeral 272). In a case of a work on an important road having a high traffic volume, a constraint condition because of the surrounding environment based on the surrounding environment information 109, such that it is difficult to regulate traffic for a long time may be additionally presented.

The inspector 211A by rope access is presented as the access means for accessing the inspection position (2) (denoted by reference numeral 274). According to the surrounding environment information 109, a tree 284 is present on the footing, and a vehicle cannot enter. Therefore, access of the inspector 211A by the rope access is presented as the access means for the inspection position (2).

The aerial work vehicle 203 is presented as the access means for accessing the inspection position (3) (denoted by reference numeral 276). The inspection position (3) is present on a ground surface 282 and thus, can be accessed by the aerial work vehicle 203.

The unmanned flying object 214 is presented as the access means for accessing the inspection position (4) (denoted by reference numeral 278). The inspection position (4) is present on a water surface 286. Thus, the inspection position (4) can be accessed by the unmanned flying object 214. The unmanned flying object 214 cannot fly in a place where wind is strong. However, according to the surrounding environment information 109, since wind is weak around the inspection position (4), the unmanned flying object 214 can fly. Thus, the unmanned flying object 214 is presented.

The bridge inspection ship 216 is presented as the access means for accessing the inspection position (5) (denoted by reference numeral 280). The inspection position (5) is presented on a water surface. Thus, the bridge inspection ship 216 is presented.

In a case where an under surface is the water surface 286 as in the case of the inspection positions (4) and (5), access by the unmanned flying object 214, the bridge inspection ship 216, and a floating scaffold is necessary.

As described so far, in the present embodiment, information for access by the access means for accessing the designated inspection position is presented based on the accessible range information 107 and the surrounding environment information 109. Accordingly, effective access means corresponding to the surrounding environment can be presented to the user.

<Third Embodiment>

Next, a third embodiment will be described. In the present embodiment, an estimate of an inspection time is also presented in addition to the presentation of the access means.

[Required Unit Inspection Time Information]

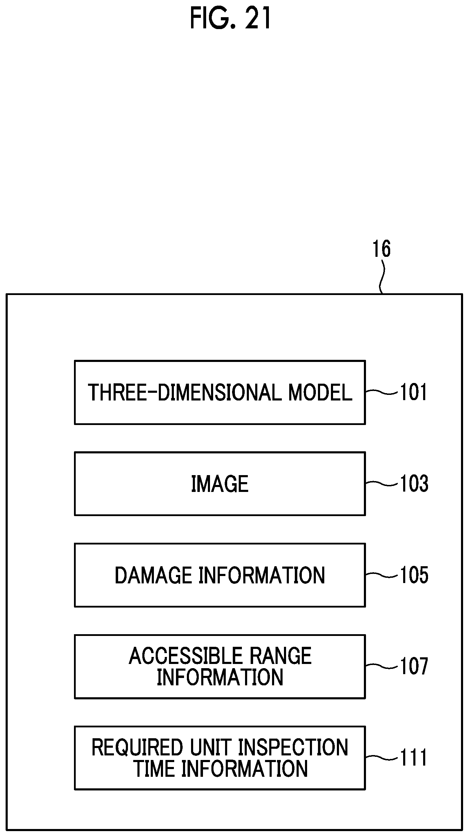

Fig. 21 is a diagram illustrating the information and the like stored in the storage unit 16 of the present embodiment. Parts already described using Fig. 3 will be designated by the same reference numerals and will not be described.

The storage unit 16 of the present embodiment mainly stores the three-dimensional model 101, the image 103, the damage information 105, the accessible range information 107, and required unit inspection time information 111.

The required unit inspection time information 111 is information related to a time necessary for inspection. For example, the required unit inspection time information 111 has information related to a preparation time, a unit inspection time, and a withdrawal time of the access means. A required unit inspection time can be changed in accordance with a situation of the user. For example, the situation of the user is a skill level of the inspector for handling the access means.

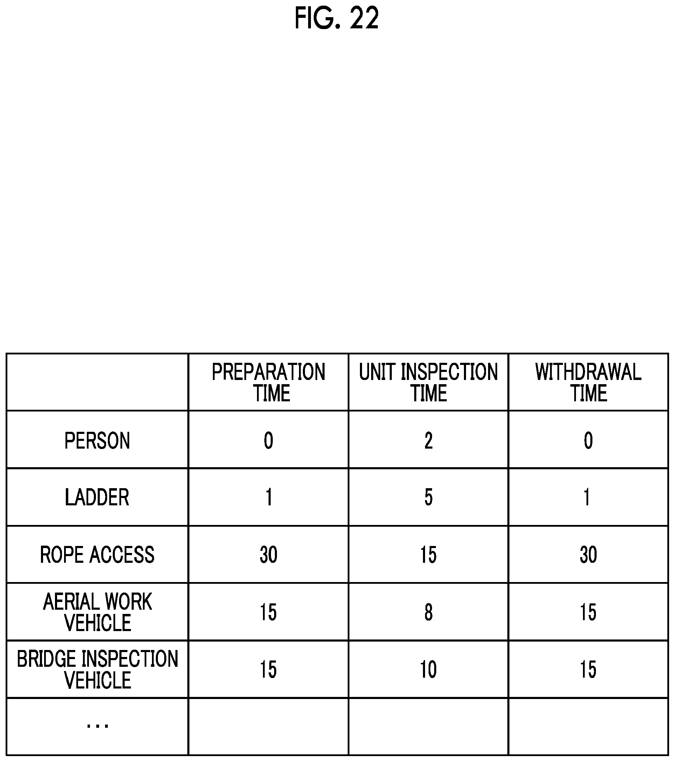

Fig. 22 is a diagram illustrating an example of the required unit inspection time for each type of the access means.

In Fig. 22, information related to the preparation time, the unit inspection time, and the withdrawal time of the access means of each of "person", "ladder", "rope access", "aerial work vehicle", and "bridge inspection vehicle" is illustrated.

The information acquisition unit 51 acquires the required unit inspection time from the storage unit 16. The information display unit 57 calculates at least one of a required time for each inspection position or a required time for performing inspection at all inspection positions based on the inspection position and the required unit inspection time information 111 and displays the calculated required time.

[Calculation of Inspection Time]

As will be illustrated below, the information display unit 57 calculates the required time with respect to the inspection position (1) to the inspection position (4) described using Figs. 16A and 16B based on the required unit inspection time information 111 illustrated in Fig. 22. In Fig. 22, the preparation time, the unit inspection time, and the withdrawal time of the access means of each of "person", "ladder", "rope access", "aerial work vehicle", and "bridge inspection vehicle" are illustrated.

The information display unit 57 calculates an inspection time of the inspection position (1) as follows.

$$\text{Inspection time of inspection position (1)} = \text{installation time of access means A} + \text{unit inspection time of access means A} \times \text{inspection area of deck slab} + \text{withdrawal time of access means A}$$

The information display unit 57 calculates an inspection time of the inspection position (2) as follows.

Inspection time of inspection position (2) = installation time of access means B + unit inspection time of access means B × inspection area of upper portion of pier + withdrawal time of access means B

The information display unit 57 calculates an inspection time of the inspection position (3) as follows.

Inspection time of inspection position (3) = installation time of access means C + unit inspection time of access means C × inspection area of middle portion of pier + withdrawal time of access means C

The information display unit 57 calculates an inspection time of the inspection position (4) as follows.

Inspection time of inspection position (4) = installation time of access means D + unit inspection time of access means D × inspection area of lower portion of pier + withdrawal time of access means D

Candidates of the access means A are rope access and the bridge inspection vehicle 207. Candidates of the access means B are rope access and the bridge inspection vehicle 207. Candidates of the access means C are rope access, the aerial work vehicle 203, and the bridge inspection vehicle 207. Candidates of the access means D are the ladder 213, rope access, the aerial work vehicle 203, and the bridge inspection vehicle 207. The information display unit 57 calculates the inspection time of each inspection position based on the above equations describing the inspection times of the inspection position (1), the inspection position (2), the inspection position (3), and the inspection position (4) and the required unit inspection time information 111 illustrated in Fig. 22.

In addition, the information display unit 57 can calculate a total inspection time for performing inspection at all of the inspection positions (1) to (4). For example, the information display unit 57 can calculate the total inspection time for each combination of the candidates of the access means A to D and present a combination of the access means (access means A/access means B/access means C/access means D) having the shortest inspection time. In a case where the same access means is used at a plurality of the inspection positions, the preparation time and the withdrawal time are reduced, and the total inspection time is calculated.

As described so far, in the present embodiment, information about the inspection time corresponding to the access means can be provided to the user in addition to the presentation of the access means. Accordingly, the user can perceive the inspection time together with the access means. In addition, the user can select the access means based on the inspection time.

<Fourth Embodiment>

Next, a fourth embodiment will be described. In the present embodiment, an estimate of an inspection expense is also presented in addition to the presentation of the access means.

[Expense Information]

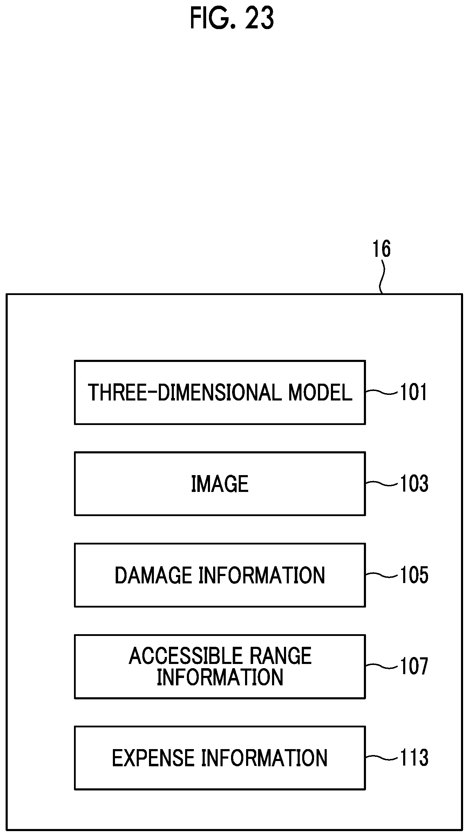

Fig. 23 is a diagram illustrating the information and the like stored in the storage unit 16 of the present embodiment. Parts already described using Fig. 3 will be designated by the same reference numerals and will not be described.

The storage unit 16 of the present embodiment mainly stores the three-dimensional model 101, the image 103, the damage information 105, the accessible range information 107, and expense information 113. Parts already described using Fig. 3 will be designated by the same reference numerals and will not be described.

The expense information 113 is information related to an expense necessary for inspection. For example, the expense information 113 is composed of an inspection expense (visual inspection + tapping, imaging, traffic regulations, and the like), a rental expense, and a preparation (arrangement and the like) expense. The expense information 113 can be changed in accordance with the situation of the user. As the situation of the user, for example, the rental expense is set to 0 in a case where the user possesses the access means.

[Calculation of Inspection Expense]

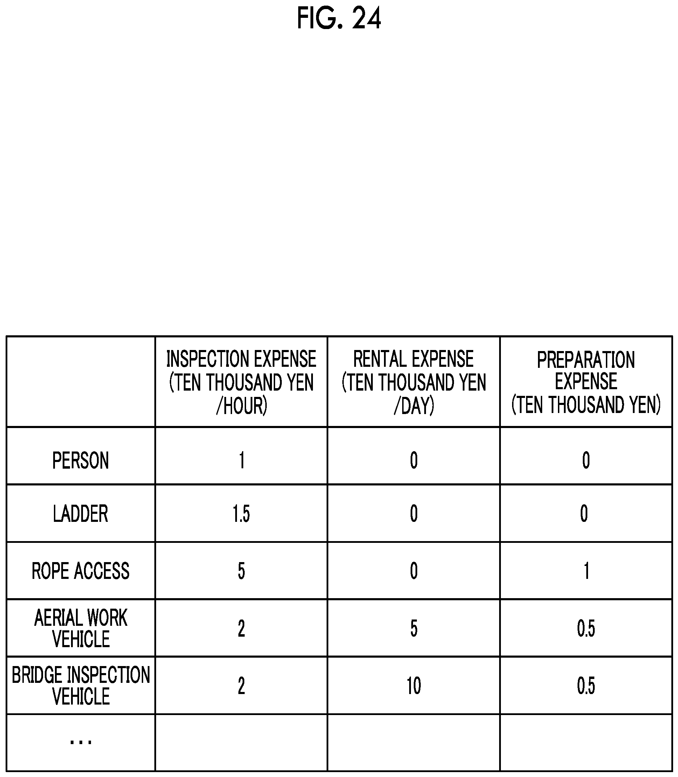

Fig. 24 is a diagram illustrating an example of the expense information. As will be illustrated below, the information display unit 57 calculates the inspection expense with respect to the inspection position (1) to the inspection position (4) described using Figs. 16A and 16B based on the expense information 113 illustrated in Fig. 24. In the expense information 113, the inspection expense, the rental expense, and the preparation expense of the access means of each of "person", "ladder", "rope access", "aerial work vehicle", and "bridge inspection vehicle" are illustrated.

The information display unit 57 calculates an expense based on the inspection position and the expense information 113. For example, the inspection expense is calculated for the inspection position (1) to the inspection position (4) described using Figs. 16A and 16B as follows.

The information display unit 57 calculates the inspection expense of the inspection position (1) as follows.

$$\text{Expense of inspection position (1)} = \text{inspection time of access means A} \times \text{inspection expense of access means A} + \text{rental expense of access means A} + \text{preparation expense of access means A}$$

The information display unit 57 calculates the inspection expense of the inspection position (2) as follows.

$$\text{Expense of inspection position (2)} = \text{inspection time of access means B} \times \text{inspection expense of access means B} + \text{rental expense of access means B} + \text{preparation expense of access means B}$$

The information display unit 57 calculates the inspection expense of the inspection position (3) as follows.

$$\text{Expense of inspection position (3)} = \text{inspection time of access means C} \times \text{inspection expense of access means C} + \text{rental expense of access means C} + \text{preparation expense of access means C}$$

The information display unit 57 calculates the inspection expense of the inspection position (4) as follows.

$$\text{Expense of inspection position (4)} = \text{inspection time of access means D} \times \text{inspection expense of access means D} + \text{rental expense of access means D} + \text{preparation expense of access means D}$$

Candidates of the access means A are rope access and the bridge inspection vehicle 207. Candidates of the access means B are rope access and the bridge inspection vehicle 207. Candidates of the access means C are rope access, the aerial work vehicle 203, and the bridge inspection vehicle 207. Candidates of the access means D are the ladder 213, rope access, the aerial work vehicle 203, and the bridge inspection vehicle 207. The information display unit 57 calculates the inspection expense of each inspection position based on the above equations describing the inspection times of the inspection position (1), the inspection position (2), the inspection position (3), and the inspection position (4) and the expense information 113 illustrated in Fig. 24.

In addition, the information display unit 57 can calculate a total expense for performing inspection at all of the inspection positions (1) to (4). For example, the information display unit 57 calculates the total expense for each combination of the candidates of the access means A to D and presents a combination of the access means (access means A/access means B/access means C/access means D) having the lowest expense. In a case where the same access means is used at a plurality of the inspection positions, the rental expense and the preparation expense are reduced, and the total expense is calculated.

As described so far, in the present embodiment, information related to the inspection expense corresponding to the access means can be provided to the user in addition to the presentation of the access means. Accordingly, the user can perceive the inspection expense together with the access means. In addition, the user can select the access means based on the inspection expense.

<Fifth Embodiment>

Next, a fifth embodiment will be described. In the present embodiment, an imaging position for imaging the inspection position is presented.

[Imaging Condition]

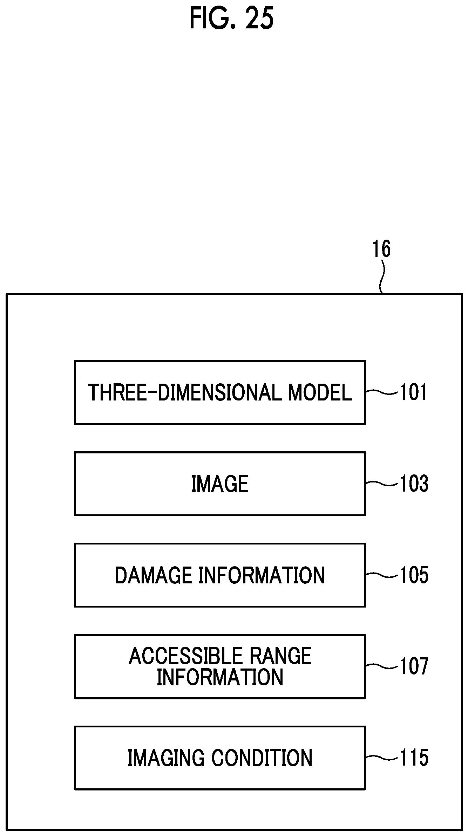

Fig. 25 is a diagram illustrating the information and the like stored in the storage unit 16 of the present embodiment. Parts already described using Fig. 3 will be designated by the same reference numerals and will not be described.
The storage unit 16 of the present embodiment mainly stores the three-dimensional model 101, the image 103, the damage information 105, the accessible range information 107, and an imaging condition 115.
The imaging condition 115 is a condition for acquiring the captured image used for inspection. For example, the imaging condition 115 includes at least one of a subject resolution, a permissible tilt angle, or range information of a focal length.

[Calculation of Imaging Position]

The information acquisition unit 51 acquires the imaging condition 115 from the storage unit 16. The information display unit 57 calculates the imaging position from the inspection position designated on the three-dimensional model, the accessible range information 107, and the imaging condition 115. Specifically, the information display unit 57 calculates and presents the imaging position for imaging the inspection position from the imaging condition 115. Furthermore, the information display unit 57 presents access means for accessing the calculated imaging position.

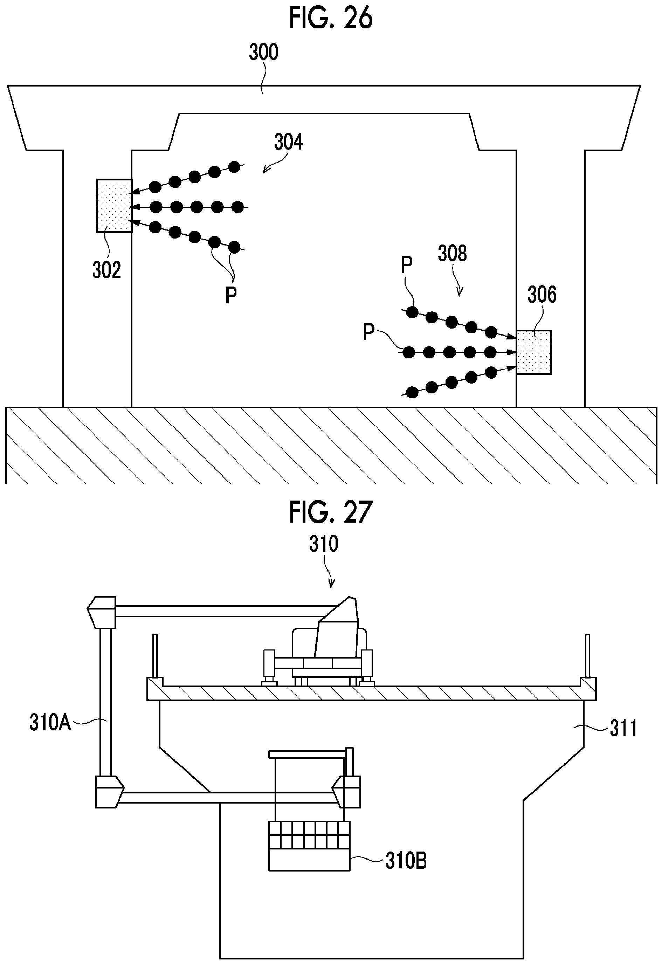

Fig. 26 is a diagram for describing the presentation of the imaging position.
In Fig. 26, a three-dimensional model 300 of a bridge is illustrated, and an inspection position 302 and an inspection position 306 are designated on the three-dimensional model 300. The information display unit 57 presents a candidate group 304 of the imaging position for the inspection position 302 and a candidate group 308 of the imaging position for the inspection position 306. The inspection position with respect to the inspection position is not necessarily one part, and a candidate group of the imaging position is present. Accordingly, the information display unit 57 calculates and presents the candidate group for each inspection position. In the case illustrated in Fig. 26, while the imaging position is schematically illustrated by a point P, an imaging position candidate group has a continuously changing angle and/or distance and is continuously present. Specifically, the imaging position candidate group has a range of an imaging angle satisfying the imaging condition 115 in accordance with the permissible tilt angle. In addition, the imaging position candidate group has a range of an imaging distance satisfying the imaging condition (desired subject resolution) 115 in accordance with the range of the focal length. While the information display unit 57 presents the access means by which at least one in the calculated candidate group can be accessed, the presentation of the access means is omitted in the case illustrated in Fig. 26.
As described so far, in the present embodiment, the imaging position for imaging the inspection position and the access means for accessing the imaging position are presented. Accordingly, the user can easily perceive the imaging position and the access means for accessing the imaging position.

<Example of Other Types of Access Means>

In the embodiment, various types of the access means are employed in addition to the above access means to the inspection position. Hereinafter, examples of other types of the access means will be described.
Fig. 27 is a diagram illustrating a gondola vehicle that is an example of the access means.
A gondola vehicle 310 moves a gondola 310B under a bridge 311 by moving a boom 310A. The inspector can access the inspection position by moving the gondola 310B of the gondola vehicle 310 in an up-down direction using wire.

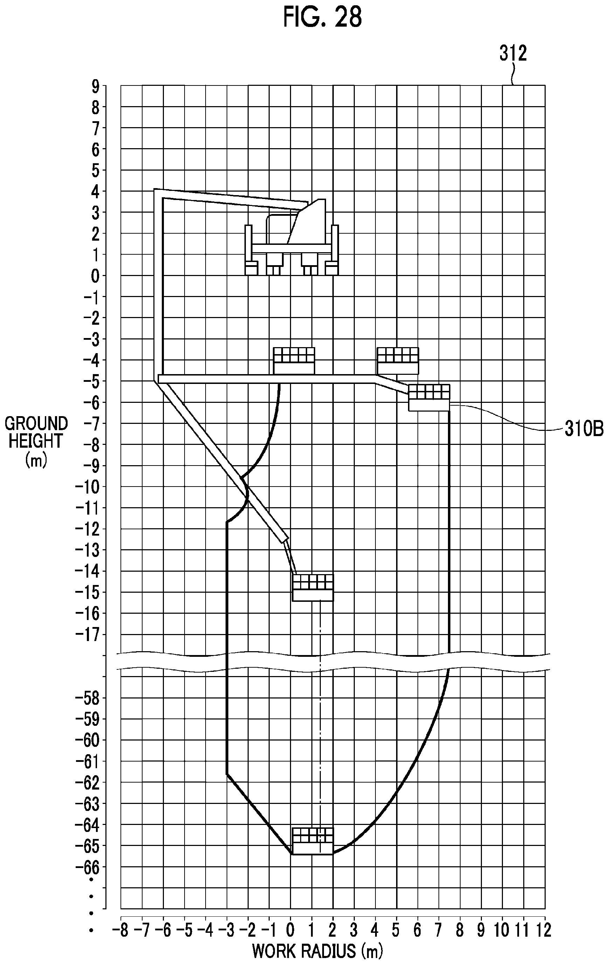

Fig. 28 is a diagram illustrating the work range diagram that is an example of the accessible range information 107 of the gondola vehicle 310.
A work range diagram 312 illustrates a work range of the gondola vehicle 310. Specifically, the work range diagram 312 illustrates a reach range in the vertical direction and a work radius in the horizontal direction of the gondola 310B of the gondola vehicle 310.

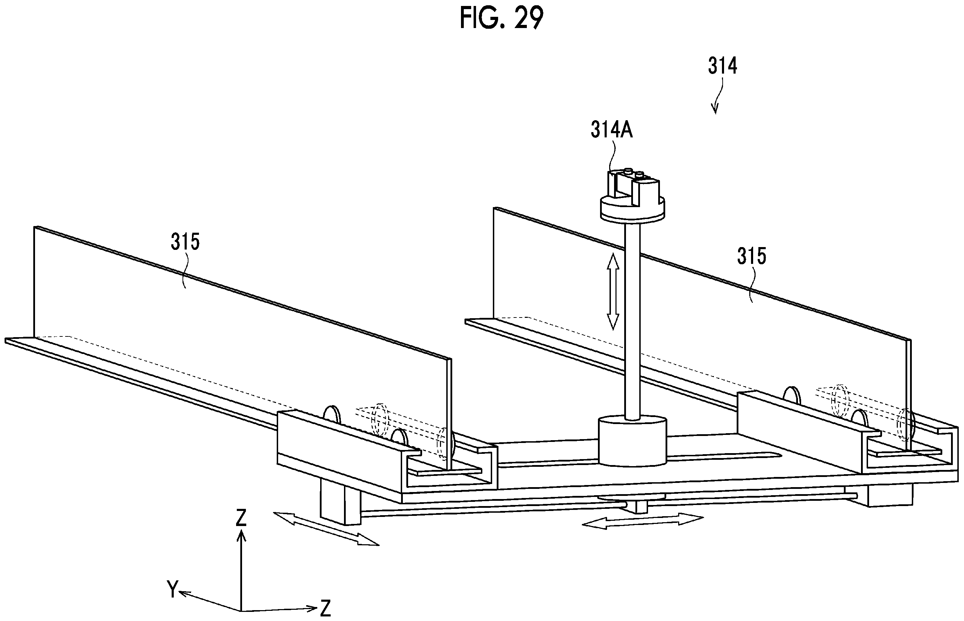

Fig. 29 is a diagram illustrating a suspended robot that is an example of the access means.
A suspended robot 314 is installed in a part of a bridge 315 and is manually or automatically operated. The suspended robot 314 comprises a camera 314A and can perform imaging close to the inspection position.

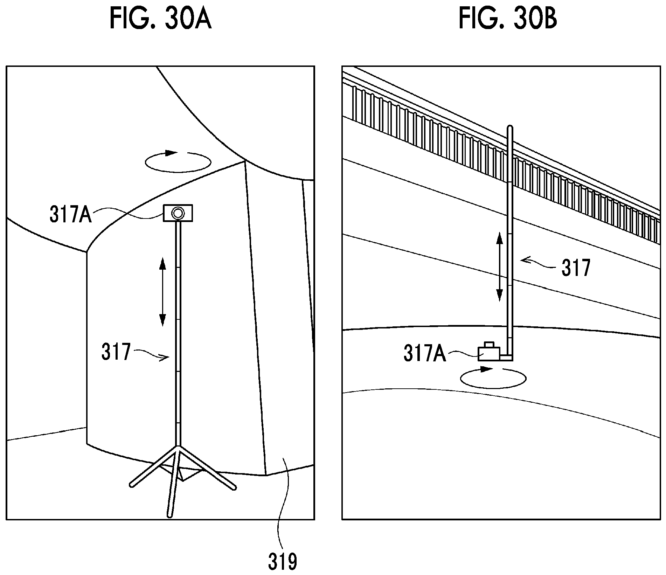

Figs. 30A and 30B are diagrams illustrating a pole camera that is an example of the access means.

A pole camera 317 illustrated in Fig. 30A images an inspection position of a bridge 319 from the ground. By using the pole camera 317, the inspector can acquire a captured image of the inspection position present in an upper portion of the bridge 319 using a camera 317A.

The pole camera 317 illustrated in Fig. 30B images the inspection position by directing the pole camera 317 downward from the bridge 319 to the inspection position of the bridge 319. By directing the pole camera 317 downward, the inspector can acquire a captured image of an underside of the bridge 319 using the camera 317A.

<Other>

In the above description, while the information acquisition unit 51 has been described with respect to a form of acquiring the information stored in the storage unit 16, the present invention is not limited thereto. For example, in a case where necessary information is not stored in the storage unit 16, the information acquisition unit 51 may acquire information from the outside via the input-output interface 12. Specifically, the information acquisition unit 51 acquires information input via the input-output interface 12 from the outside of the inspection support device 10 of the structure.

In the embodiments, for example, a hardware structure of a processing unit executing various types of processing includes various processors illustrated below. The various processors include a central processing unit (CPU) that is a general-purpose processor functioning as various processing units by executing software (program), a programmable logic device (PLD) such as a field programmable gate array (FPGA) that is a processor having a circuit configuration changeable after manufacturing, and a dedicated electric circuit or the like such as an application specific integrated circuit (ASIC) that is a processor having a circuit configuration dedicatedly designed to execute a specific type of processing.

One processing unit may be composed of one of the various processors or may be composed of a combination of two or more processors of the same type or different types (for example, a plurality of FPGAs or a combination of the CPU and the FPGA). In addition, a plurality of processing units may be composed of one processor. As an example in which the plurality of processing units are composed of one processor, first, as represented by a computer such as a client or a server, a form in which one processor is composed of a combination of one or more CPUs and software and the processor functions as the plurality of processing units is possible. Second, as represented by a system on chip (SoC) or the like, a form of using a processor that implements functions of the entire system including the plurality of processing units in one integrated circuit (IC) chip is possible. Accordingly, the various processing units are configured using one or more of the various processors as a hardware structure.

Furthermore, the hardware structure of the various processors is more specifically an electric circuit (circuitry) in which circuit elements such as semiconductor elements are combined.

Each configuration and the functions described above can be appropriately implemented by any hardware, software, or a combination of both thereof. For example, the present invention can also be applied to a program causing a computer to execute the above processing steps (processing procedures), a computer readable recording medium (non-transitory recording medium) on which the program is recorded, or a computer on which the program can be installed.

While the examples of the present invention have been described so far, the present invention is not limited to the embodiments and can obviously be subjected to various modifications without departing from the gist of the present invention.

Explanation of References

10: inspection support device
12: input-output interface
16: storage unit
18: operating unit
20: CPU
22: RAM
24: ROM
26: display control unit
30: display unit
51: information acquisition unit
53: three-dimensional model display unit
55: designation receiving unit
57: information display unit
101: three-dimensional model

103: image
105: damage information
107: accessible range information
109: surrounding environment information
111: required unit inspection time information
113: expense information
115: imaging condition
203: aerial work vehicle
207: bridge inspection vehicle
213: ladder
214: unmanned flying object
216: bridge inspection ship
310: gondola vehicle
314: suspended robot
317: pole camera

**Claims**

1. An inspection support device of a structure, comprising
   a processor configured to:

   acquire a three-dimensional model of a structure that is an inspection target, and accessible range information of a plurality of types of access means for accessing an inspection position of the structure;
   display the three-dimensional model on a display unit;
   receive a designation of the inspection position on the displayed three-dimensional model; and
   display information about one or more types of the access means for accessing the inspection position on the display unit based on the received inspection position and the accessible range information.

2. The inspection support device of a structure according to claim 1, further comprising:

   a memory that stores the three-dimensional model and the accessible range information,
   wherein the processor is configured to acquire the three-dimensional model and the accessible range information from the memory.

3. The inspection support device of a structure according to claim 2,

   wherein the memory stores an image of the structure associated with the three-dimensional model, and
   the processor is configured to:

   detect a damage from the image; and
   automatically receive the designation of the inspection position based on the detected damage.

4. The inspection support device of a structure according to claim 2 or 3,

   wherein the memory stores damage information associated with the three-dimensional model, and
   the processor is configured to display the damage information on the three-dimensional model.

5. The inspection support device of a structure according to any one of claims 1 to 4,
   wherein the processor is configured to:

   acquire surrounding environment information indicating a surrounding environment of the structure; and
   display the information about the access means for accessing the inspection position based on the surrounding environment information, the inspection position, and the accessible range information.

6. The inspection support device of a structure according to claim 5, further comprising:

   a memory that stores the surrounding environment information,

wherein the processor is configured to acquire the surrounding environment information from the memory.

7. The inspection support device of a structure according to any one of claims 1 to 6,
   wherein the processor is configured to:

   acquire required unit inspection time information indicating a time required for inspection for each type of the access means; and
   in a case of displaying the information about the access means, display the required unit inspection time information corresponding to the displayed information about the access means.

8. The inspection support device of a structure according to claim 7, further comprising:

   a memory that stores the required unit inspection time information,
   wherein the processor is configured to acquire the required unit inspection time information from the memory.

9. The inspection support device of a structure according to claim 7 or 8,
   wherein the processor is configured to:

   calculate at least one of a required time for each inspection position or a required time for performing inspection at all inspection positions based on the inspection position and the required unit inspection time information; and
   display the calculated required time.

10. The inspection support device of a structure according to any one of claims 1 to 9,
    wherein the processor is configured to:

    acquire expense information indicating an expense required for inspection for each type of the access means; and
    in a case of displaying the information about the access means, display the expense information corresponding to the displayed information about the access means.

11. The inspection support device of a structure according to claim 10, further comprising:

    a memory that stores the expense information,
    wherein the processor is configured to acquire the expense information from the memory.

12. The inspection support device of a structure according to claim 10 or 11,
    wherein the processor is configured to:

    calculate at least one of an inspection expense for each inspection position or an inspection expense for performing inspection at all inspection positions based on the inspection position and the expense information; and
    display the calculated inspection expense.

13. The inspection support device of a structure according to any one of claims 1 to 12,
    wherein the inspection position is a position at which the structure is viewed or tapped.

14. The inspection support device of a structure according to any one of claims 1 to 13,
    wherein the inspection position is an imaging target position indicating a range in which the structure is imaged.

15. The inspection support device of a structure according to claim 14,
    wherein the processor is configured to:

    acquire an imaging condition for imaging the structure;
    acquire an imaging position based on the inspection position and the imaging condition; and
    display the information about the access means with respect to the imaging position.

16. The inspection support device of a structure according to claim 15, further comprising:

    a memory that stores the imaging condition,
    wherein the processor is configured to acquire the imaging condition from the memory.

**17.** The inspection support device of a structure according to claim 15 or 16,
wherein the processor is configured to display the imaging position.

**18.** An inspection support method of a structure using an inspection support device of a structure including a processor, the method causing the processor to execute:

a step of acquiring a three-dimensional model of a structure that is an inspection target, and accessible range information of a plurality of types of access means for accessing an inspection position of the structure;
a step of displaying the three-dimensional model on a display unit;
a step of receiving a designation of the inspection position on the displayed three-dimensional model; and
a step of displaying information about one or more types of the access means for accessing the inspection position on the display unit based on the received inspection position and the accessible range information.

**19.** A program causing an inspection support device of a structure including a processor to execute an inspection support method of a structure, the program causing the processor to execute:

a step of acquiring a three-dimensional model of a structure that is an inspection target, and accessible range information of a plurality of types of access means for accessing an inspection position of the structure;
a step of displaying the three-dimensional model on a display unit;
a step of receiving a designation of the inspection position on the displayed three-dimensional model; and
a step of displaying information about one or more types of the access means for accessing the inspection position on the display unit based on the received inspection position and the accessible range information.

**20.** A non-transitory computer readable recording medium on which the program according to claim 19 is recorded.

# FIG. 1

10

```
┌──────────────────────────────────────────────────────────┐
│                                                            │
│    12                              20                      │
│  ┌──────────────┐              ┌──────────────┐            │
│  │ INPUT-OUTPUT │◄────►  ◄────►│     CPU      │            │
│  │  INTERFACE   │              │              │            │
│  └──────────────┘              └──────────────┘            │
│                                                            │
│                                    22                      │
│                                ┌──────────────┐            │
│                         ◄────► │     RAM      │            │
│    16                          └──────────────┘            │
│  ┌──────────────┐                                          │
│  │ STORAGE UNIT │◄────►          24                        │
│  └──────────────┘              ┌──────────────┐            │
│                         ◄────► │     ROM      │            │
│    18                          └──────────────┘            │
│  ┌──────────────┐                                          │
│  │  OPERATING   │──────►         26              30         │
│  │    UNIT      │              ┌──────────────┐ ┌──────────┐│
│  └──────────────┘       ──────►│   DISPLAY    │►│ DISPLAY  ││
│                                │ CONTROL UNIT │ │   UNIT   ││
│                                └──────────────┘ └──────────┘│
│                                                            │
│        INSPECTION SUPPORT DEVICE OF STRUCTURE              │
└──────────────────────────────────────────────────────────┘
```

# FIG. 2

20

```
┌──────────────────────────────────────────┐
│                                            │
│   ┌──────────────────────────┐             │
│   │      INFORMATION         │             │
│   │    ACQUISITION UNIT      │──51         │
│   └──────────────────────────┘             │
│                                            │
│   ┌──────────────────────────┐             │
│   │  THREE-DIMENSIONAL MODEL │             │
│   │       DISPLAY UNIT       │──53         │
│   └──────────────────────────┘             │
│                                            │
│   ┌──────────────────────────┐             │
│   │ DESIGNATION RECEIVING UNIT│──55        │
│   └──────────────────────────┘             │
│                                            │
│   ┌──────────────────────────┐             │
│   │  INFORMATION DISPLAY UNIT │──57        │
│   └──────────────────────────┘             │
│                                            │
└──────────────────────────────────────────┘
```

# FIG. 3

16

| THREE-DIMENSIONAL MODEL | ~101 |
| IMAGE | ~103 |
| DAMAGE INFORMATION | ~105 |
| ACCESSIBLE RANGE INFORMATION | ~107 |

# FIG. 4

```
        ┌─────────────┐
        │    START    │
        └─────────────┘
               │
               ▼
┌──────────────────────────────────────┐
│   ACQUIRE THREE-DIMENSIONAL MODE      │───S1
│   AND ACCESSIBLE RANGE INFORMATION    │
└──────────────────────────────────────┘
               │
               ▼
┌──────────────────────────────────────┐
│    DISPLAY THREE-DIMENSIONAL MODEL    │───S2
│          ON DISPLAY UNIT              │
└──────────────────────────────────────┘
               │
               ▼
┌──────────────────────────────────────┐
│  RECEIVE DESIGNATION OF INSPECTION POSITION │───S3
└──────────────────────────────────────┘
               │
               ▼
┌──────────────────────────────────────┐
│  DISPLAY INFORMATION ABOUT ACCESS MEANS │───S4
│          ON DISPLAY UNIT              │
└──────────────────────────────────────┘
               │
               ▼
        ┌─────────────┐
        │     END     │
        └─────────────┘
```

FIG. 5

(A)

(B)

## FIG. 6

(A)

M2          30

(B)

M2   F2          30

EP 4 191 507 A1

# FIG. 7

EP 4 191 507 A1

(A)

M1  D1  30

(B)

M1  D1  30

F3

FIG. 8

# FIG. 9

# FIG. 10

# FIG. 11

# FIG. 12

209

207B

GROUND
HEIGHT
(m)

WORK RADIUS (m)

## FIG. 13

# FIG. 14A

210

211A

# FIG. 14B

210

211B

## FIG. 15

## FIG. 16A

250
252
(1)
207
254
(2)
LOWER LIMIT OF BRIDGE INSPECTION VEHICLE
UPPER LIMIT OF AERIAL WORK VEHICLE
211A
256
(3)
(4)
258
203

## FIG. 16B

212

| ACCESSIBILITY | (1) | (2) | (3) | (4) |
|---|---|---|---|---|
| PERSON | × | × | × | × |
| LADDER | × | × | × | ○ |
| ROPE ACCESS | ○ | ○ | ○ | ○ |
| AERIAL WORK VEHICLE | × | × | ○ | ○ |
| BRIDGE INSPECTION VEHICLE | ○ | ○ | ○ | ○ |
| . . . | | | | |

EP 4 191 507 A1

# FIG. 17

16

| THREE-DIMENSIONAL MODEL | ~101 |

| IMAGE | ~103 |

| DAMAGE INFORMATION | ~105 |

| ACCESSIBLE RANGE INFORMATION | ~107 |

| SURROUNDING ENVIRONMENT INFORMATION | ~109 |

FIG. 18

214

214A

FIG. 19

216

216B

216A

# FIG. 20

EP 4 191 507 A1

# FIG. 21

16

THREE-DIMENSIONAL MODEL — 101

IMAGE — 103

DAMAGE INFORMATION — 105

ACCESSIBLE RANGE
INFORMATION — 107

REQUIRED UNIT INSPECTION
TIME INFORMATION — 111

# FIG. 22

|  | PREPARATION TIME | UNIT INSPECTION TIME | WITHDRAWAL TIME |
|---|---|---|---|
| PERSON | 0 | 2 | 0 |
| LADDER | 1 | 5 | 1 |
| ROPE ACCESS | 30 | 15 | 30 |
| AERIAL WORK VEHICLE | 15 | 8 | 15 |
| BRIDGE INSPECTION VEHICLE | 15 | 10 | 15 |
| . . . |  |  |  |

# FIG. 23

16

THREE-DIMENSIONAL MODEL — 101

IMAGE — 103

DAMAGE INFORMATION — 105

ACCESSIBLE RANGE INFORMATION — 107

EXPENSE INFORMATION — 113

# FIG. 24

|  | INSPECTION EXPENSE (TEN THOUSAND YEN /HOUR) | RENTAL EXPENSE (TEN THOUSAND YEN /DAY) | PREPARATION EXPENSE (TEN THOUSAND YEN) |
|---|---|---|---|
| PERSON | 1 | 0 | 0 |
| LADDER | 1.5 | 0 | 0 |
| ROPE ACCESS | 5 | 0 | 1 |
| AERIAL WORK VEHICLE | 2 | 5 | 0.5 |
| BRIDGE INSPECTION VEHICLE | 2 | 10 | 0.5 |
| . . . |  |  |  |

# FIG. 25

16

| THREE-DIMENSIONAL MODEL | ～101 |
|---|---|
| IMAGE | ～103 |
| DAMAGE INFORMATION | ～105 |
| ACCESSIBLE RANGE INFORMATION | ～107 |
| IMAGING CONDITION | ～115 |

## FIG. 26

300

304

302

308

P

P

P

306

## FIG. 27

310

310A

311

310B

# FIG. 28

# FIG. 29

314

314A

315

315

EP 4 191 507 A1

# FIG. 30A

317A

317

319

# FIG. 30B

317

317A

## INTERNATIONAL SEARCH REPORT

International application No.

**PCT/JP2021/027443**

### A. CLASSIFICATION OF SUBJECT MATTER

*G06Q 50/08*(2012.01)i
FI:   G06Q50/08

According to International Patent Classification (IPC) or to both national classification and IPC

### B. FIELDS SEARCHED

Minimum documentation searched (classification system followed by classification symbols)

G06Q10/00-99/00

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2013-256815 A (HITACHI GE NUCLEAR ENERGY LTD.) 26 December 2013 (2013-12-26) entire text, all drawings | 1-20 |
| A | JP 2019-175350 A (RAILWAY TECHNICAL RESEARCH INSTITUTE) 10 October 2019 (2019-10-10) entire text, all drawings | 1-20 |
| A | WO 2020/027334 A1 (TADANO LTD.) 06 February 2020 (2020-02-06) entire text, all drawings | 1-20 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **04 October 2021** | **12 October 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT
### Information on patent family members

| International application No. |
|---|
| **PCT/JP2021/027443** |

| Patent document cited in search report | | | Publication date (day/month/year) | Patent family member(s) | Publication date (day/month/year) |
|---|---|---|---|---|---|
| JP | 2013-256815 | A | 26 December 2013 | (Family: none) | |
| JP | 2019-175350 | A | 10 October 2019 | (Family: none) | |
| WO | 2020/027334 | A1 | 06 February 2020 | (Family: none) | |

Form PCT/ISA/210 (patent family annex) (January 2015)

**EP 4 191 507 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002222281 A